# EUROPEAN PATENT APPLICATION

(11) **EP 4 737 915 A1**
(43) Date of publication of application: **06.05.2026**
(21) Application number: 24861530.4
(22) Date of filing: 07.05.2024
(51) Int. Cl.: G01R 19/00, G01R 15/14, G01R 19/25

(54) **SHUNT MODULE, CURRENT ACQUISITION SYSTEM AND CIRCUIT, AND VEHICLE**

(30) Priority: 08.09.2023 CN 202322441243 U
(71) Applicant: Contemporary Amperex Technology Co., Limited, Ningde, Fujian 352100 (CN); Contemporary Amperex Runzhi Software Technology Limited, Ningde, Fujian 352100 (CN)
(72) Inventor: WU, Zhihong, Ningde, Fujian 352100 (CN); MA, Hang, Ningde, Fujian 352100 (CN); LI, Qiandeng, Ningde, Fujian 352100 (CN)
(74) Representative: Lorenz Seidler Gossel Part. mbB
(86) International application number: PCT/CN2024/091495
(87) International publication number: WO 2025/050681

(57) **Abstract**

Provided in the embodiments of the present application are a shunt module, a current acquisition system, a current acquisition circuit, and a vehicle. The shunt module includes: a plurality of conductive connectors arranged in sequence; and a plurality of signal conversion components, different signal conversion components in the plurality of signal conversion components being arranged between two different adjacent conductive connectors, each of the signal conversion components being provided with a first sampling point, and the sampling point being configured to acquire electrical signals.

## Description

### CROSS-REFERENCE TO RELATED APPLICATIONS

The present application claims priority to Chinese Patent Application No. 202322441243.6, filed on September 8, 2023 and entitled "SHUNT MODULE, CURRENT ACQUISITION SYSTEM, CURRENT ACQUISITION CIRCUIT, AND VEHICLE", which is incorporated herein by reference in its entirety.

### TECHNICAL FIELD

The present application relates to the technical field of battery management systems, in particular, to a shunt module, a current acquisition system, a current acquisition circuit, and a vehicle.

### BACKGROUND

As the new energy vehicle industry continues to develop rapidly, the detection of battery management systems is particularly important, and especially, the current data of vehicles while driving and charging needs to be monitored in real time. Currently, current detection usually uses two independent circuits, namely a shunt module current sampling circuit and a Hall sensor current sampling circuit, for main sampling and redundant sampling to achieve the purpose of current detection. As a result, the entire current sampling module is relatively large in structure size, which is not conducive to miniaturization.

### SUMMARY OF THE INVENTION

Embodiments of the present application provide a shunt module, a current acquisition system, a current acquisition circuit, and a vehicle to solve the technical problem of a large size of a current sampling module.

According to a first aspect, an embodiment of the present application provides a shunt module, including:
a plurality of conductive connectors arranged in sequence; and
a plurality of signal conversion components, different signal conversion components in the plurality of signal conversion components being arranged between two different adjacent conductive connectors, each of the signal conversion components being provided with a first sampling point, and the sampling point being configured to acquire electrical signals.

In this embodiment, the shunt module may include conductive connectors arranged in sequence and a plurality of signal conversion components, where the plurality of signal conversion components may achieve multi-channel sampling. In this way, only the shunt module can perform main sampling and redundant sampling to achieve the purpose of current detection, reduce the structure size, and facilitate miniaturization. At the same time, the use of a Hall sensor for sampling is avoided, which reduces the interference during the sampling process, thereby improving the current sampling accuracy.

In some embodiments, the plurality of conductive connectors are spaced apart from each other, and the signal conversion component is located within at least a portion of the interval between two adjacent conductive connectors.

In this embodiment, the plurality of conductive connectors are spaced apart from each other, and the signal conversion component is located within at least a portion of the interval between two adjacent conductive connectors, so that mutual interference between signals generated on the conductive connectors can be reduced, and the sampling accuracy is higher.

In some embodiments, the signal conversion component is arranged between each two adjacent conductive connectors.

In this embodiment, the signal conversion component is arranged between each two adjacent conductive connectors, that is, a signal conversion component is respectively arranged between each two adjacent conductive connectors, so that the structure of the shunt module is more compact, the structure size is further reduced, and miniaturization is facilitated.

In some embodiments, the shunt module further includes:
a circuit board, the circuit board being arranged on one side of the plurality of conductive connectors, and the plurality of signal conversion components being connected to the circuit board; and
a first signal transmission component arranged on the circuit board, the first signal transmission component being electrically connected to the first sampling point of each of the signal conversion components.

In this embodiment, the circuit board can achieve the electrical connection between various components of the shunt module, and the first signal transmission component can be configured to transmit the electrical signal acquired by the signal conversion component, thereby simplifying the assembly work, reducing wiring, achieving the purpose of saving space, and further reducing the structure size, which is conducive to miniaturization.

In some embodiments, the shunt module further includes:
a plurality of temperature sensors, the plurality of temperature sensors being correspondingly arranged on the plurality of signal conversion components, the plurality of temperature sensors being connected to the circuit board, each of the temperature sensors being provided with a second sampling point, and the second sampling point being configured to acquire the temperature of the signal conversion component.

In this embodiment, the temperature sensor can acquire the temperature of the signal conversion component so as to subsequently compensate for the temperature drift of the signal conversion component, thereby improving the sampling accuracy of the signal conversion component and further improving the current detection accuracy.

In some embodiments, the shunt module further includes:
a calibration mark arranged on the circuit board.

In this embodiment, an initial resistance value and a temperature compensation coefficient of the shunt module can be calibrated by the calibration mark to avoid the subsequent sampling deviation and improve the current sampling accuracy.

In some embodiments, a third sampling point is arranged on each of the plurality of conductive connectors; and
the shunt module further includes:
a plurality of second signal transmission components, the plurality of second signal transmission components being correspondingly arranged at the third sampling points of the plurality of conductive connectors, and each of the second signal transmission components being electrically connected to the corresponding third sampling point.

In this embodiment, the electrical signals acquired by the third sampling points of the plurality of conductive connectors can be transmitted through the plurality of second signal transmission components, so that the shunt module can transmit the acquired electrical signals in more flexible and diverse manners.

In some embodiments, the second signal transmission component includes:
a connecting plate, the connecting plate being attached to at least a partial region of the conductive connector and connected to the conductive connector, and the third sampling point being located within the at least partial region; and
a transmission part, the transmission part being formed by extending the connecting plate, the transmission part being electrically connected to the conductive connector through the connecting plate, and the transmission part being configured to transmit the electrical signal acquired by the conductive connector.

In this embodiment, the transmission part is electrically connected to the conductive connector through the connecting plate connected to the conductive connector, and the connecting plate is attached to the at least partial region of the conductive connector including the third sampling point, so that the contact area between the signal transmission component and the conductive connector can be increased, thereby making the connection between the signal transmission component and the corresponding conductive connector more secure, and improving the stability of the shunt module.

In some embodiments, the transmission part includes at least one contact pin.

In this embodiment, by arranging at least one contact pin on the transmission part, connection with an external device can be achieved through the contact pin, which facilitates operation during a signal transmission process.

In some embodiments, different signal conversion components have different structural features.

In this embodiment, different signal conversion components have different structural features, which facilitates identification of a plurality of signal conversion components, so that during sampling, a sampled object can be determined according to the structural features of each signal conversion component, thereby improving the sampling efficiency.

According to a second aspect, an embodiment of the present application provides a current acquisition system, including:
a battery and a sampling plate; and
a shunt module according to the first aspect,
where the battery and the sampling plate are respectively connected to the shunt module.

In this embodiment, the current acquisition system may include the above shunt module. In this way, only the shunt module can perform main sampling and redundant sampling to achieve the purpose of current detection, reduce the structure size, and facilitate miniaturization. At the same time, the use of a Hall sensor for sampling is avoided, which reduces the interference during the sampling process, thereby improving the current sampling accuracy.

According to a third aspect, an embodiment of the present application provides a current acquisition circuit, including:
a plurality of sampling modules, the plurality of sampling modules being arranged corresponding to the plurality of signal conversion components in the shunt module according to the first aspect; and
a main control module, the main control module being configured to be connected to the plurality of sampling modules respectively, and the main control module being configured to obtain a current group of the plurality of sampling modules according to the electrical signals acquired by the plurality of sampling modules.

In this embodiment, the plurality of sampling modules in the current acquisition circuit can be arranged corresponding to the plurality of signal conversion components in the shunt module, and multi-channel current acquisition can be achieved through the plurality of sampling modules, thereby avoiding the use of a Hall sensor sampling circuit for current sampling, correspondingly reducing one power supply module, and simplifying the circuit structure.

In some embodiments, the plurality of sampling modules include at least one of a differential sampling subcircuit and a single-ended sampling subcircuit.

In this embodiment, the plurality of sampling modules can select single-ended sampling or differential sampling according to actual conditions, so that the flexibility is higher, and diverse sampling scenarios and needs can be better satisfied.

According to a fourth aspect, an embodiment of the present application provides a vehicle, including the current acquisition system according to the second aspect or the current acquisition circuit according to the third aspect.

The above description is merely an overview of the technical solutions in the present application. In order that technical means of the present application can be understood more clearly so that the technical means can be implemented according to content of the specification, and in order that the above and other objectives, features, and advantages of the present application can be understood more clearly, specific embodiments of the present application are described below.

### DESCRIPTION OF DRAWINGS

In order to illustrate the technical solutions of the embodiments of the present application more clearly, the accompanying drawings required in the embodiments of the present application are briefly introduced below. Obviously, the accompanying drawings described below are only some embodiments of the present application. For those of ordinary skill in the art, other accompanying drawings can also be obtained according to these accompanying drawings without any creative effort.
FIG. 1 is a schematic structural diagram of a shunt module provided in an embodiment of the present application;
FIG. 2 is another schematic structural diagram of a shunt module provided in an embodiment of the present application;
FIG. 3 is still another schematic structural diagram of a shunt module provided in an embodiment of the present application;
FIG. 4 is a schematic structural diagram of a current acquisition system provided in an embodiment of the present application;
FIG. 5 is a schematic structural diagram of a current acquisition circuit provided in an embodiment of the present application;
FIG. 6 is another schematic structural diagram of a current acquisition circuit provided in an embodiment of the present application; and
FIG. 7 is still another schematic structural diagram of a current acquisition circuit provided in an embodiment of the present application.

### Reference numerals:

100. shunt module; 101. battery; 102. sampling plate; 1. conductive connector; 2. signal conversion component; 21. first signal conversion component; 22. second signal conversion component; 3. circuit board; 31. signal transmission component; 4. temperature sensor; 41. first temperature sensor; 42. second temperature sensor; 5. calibration mark; 500. current acquisition circuit; 51. sampling module; 52. main control module; 6. signal transmission component; 61. connecting plate; 62. transmission part; 621. contact pin.

In the accompanying drawings, the figures are not drawn to the actual scale.

### DETAILED DESCRIPTION

Embodiments of the present application are further described in detail below with reference to the accompanying drawings and embodiments. The following detailed description of the embodiments and the accompanying drawings are used to illustrate the principles of the present application by way of example, but should not be used to limit the scope of the present application, that is, the present application is not limited to the described embodiments.

In the description of the present application, it should be noted that, unless otherwise stated, "a plurality of" means two or more. The orientation or positional relationships indicated by the terms "upper", "lower", "left", "right", "inner" and "outer" are only for facilitating the description of the present application and simplifying the description, rather than indicating or implying that the apparatus or element referred to must have a particular orientation or be constructed and operated in a particular orientation, and therefore will not be interpreted as limiting the present application. In addition, the terms "first", "second" and "third" are used for descriptive purposes only, and cannot be construed as indicating or implying relative importance. "Perpendicular" is not strictly perpendicular, but within an allowable range of errors. "Parallel" is not strictly parallel, but within an allowable range of errors.

Orientation words appearing in the following description are all directions shown in the drawings, and do not limit the specific structure of the present application. In the description of the present application, it should also be noted that, unless otherwise expressly specified and limited, the terms "mount," "connected," and "connecting" should be broadly understood, for example, they may be a fixed connection or a detachable connection or be an integrated connection; or may be a direct connection or an indirect connection through an intermediate medium. For those of ordinary skill in the art, the specific meanings of the above terms in the present application may be understood according to specific circumstances.

In related technologies, the current acquisition module in current detection usually needs to use a shunt module and a Hall sensor for main sampling and redundant sampling. However, the shunt module and the Hall sensor are generally separate structures, resulting in the current acquisition module often having a relatively large structure size, which is not conducive to miniaturization. At the same time, a magnetic core of the Hall sensor requires different sizes according to the charging and discharging current. In particular, the size requirement is high in the case of high current, which is not conducive to miniaturization, and there is a risk of magnetic core saturation. In addition, the Hall sensor is susceptible to interference during the sampling process, resulting in poor sampling accuracy, affecting the reliability of verification, and thus affecting current detection results.

Based on the above problems, the applicant improves the structure of the shunt module. The technical solutions described in the embodiments of the present application are applicable to a shunt module, a current acquisition system including the shunt module, a current acquisition circuit applied to the current acquisition system, a battery management system including the shunt module, and a vehicle using the battery management system.

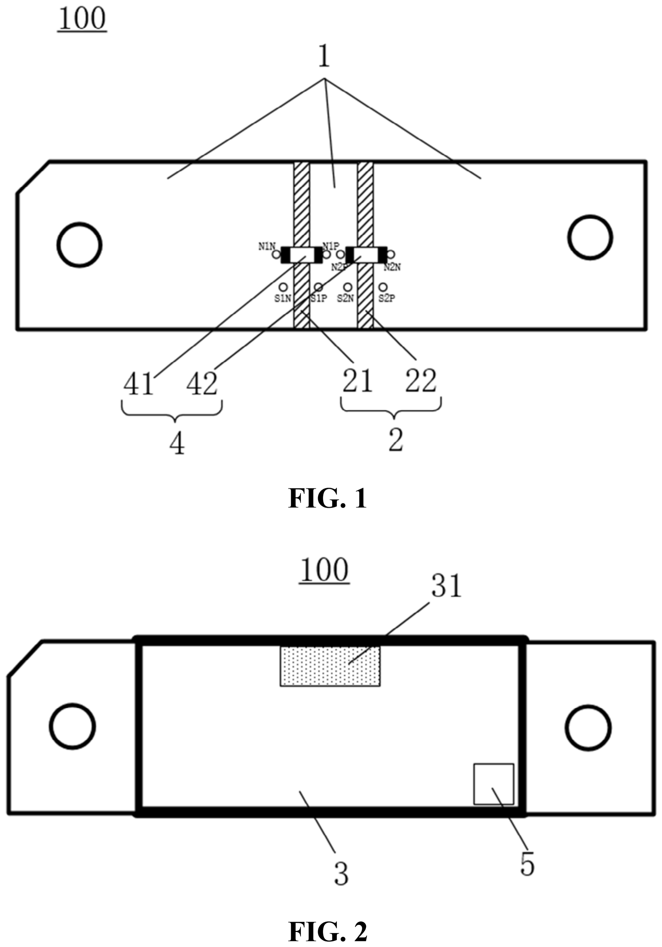

Referring to FIG. 1, FIG. 1 shows a shunt module 100 provided in some embodiments of the present application, including:
a plurality of conductive connectors 1 arranged in sequence; and
a plurality of signal conversion components 2, different signal conversion components 2 in the plurality of signal conversion components 2 being arranged between two different adjacent conductive connectors, each of the signal conversion components 2 being provided with a first sampling point, and the first sampling point of the signal conversion component 2 being configured to acquire electrical signals.

In this embodiment, the shunt module 100 may include a plurality of conductive connectors 1 and a plurality of signal conversion components 2, the number of the signal conversion components 2 is more than two, and the number of the signal conversion components is at least two.

The plurality of conductive connectors are arranged in sequence, and any two of the plurality of conductive connectors may be at least partially adjacent to each other, or the conductive connectors may be spaced apart from each other.

Different signal conversion components in the plurality of signal conversion components are arranged between two different adjacent conductive connectors, and a signal conversion component may be arranged between at least some of two adjacent conductive connectors of the plurality of signal conversion components, that is, the number of the above conductive connectors may be N, and the number of the above signal conversion components may be less than or equal to N-1, where N is an integer greater than 2.

For example, in a case that the number of the above conductive connectors is 4 and the number of the signal conversion components is 2, the four conductive connectors can be arranged in sequence to form three groups of two adjacent conductive connectors, and the two signal conversion components are respectively arranged between two adjacent conductive connectors in the three groups of two adjacent conductive connectors.

The above two adjacent conductive connectors may be understood as two conductive connectors that are adjacent to each other in terms of placement. For example, the two conductive connectors may be at least partially adjacent to each other, or the two conductive connectors may have a common interval.

It should be noted that in a case that there are two adjacent conductive connectors in the plurality of conductive connectors, the adjacent conductive connectors may be insulated, and the above signal conversion component is arranged between the adjacent conductive connectors. It may be that a partial hollow region is also provided between the adjacent conductive connectors, and the signal conversion component is embedded in the hollow region.

The above signal conversion component is arranged between two adjacent conductive connectors, which may be that the conductive connector 1 and the signal conversion component 2 may be fixedly connected and electrically conductive. Specifically, the conductive connector 1 and the signal conversion component 2 may be soldered together by electron beam soldering.

Exemplarily, taking a case where there are two signal conversion components 2, including a first signal conversion component 21 and a second signal conversion component 22, as an example, as shown in FIG. 1, the shunt module 100 may be composed of the following components from left to right: a conductive connector 1, a first signal conversion component 21, a conductive connector 1, a second signal conversion component 22, and a conductive connector 1.

The signal conversion component 2 may be any component that can convert a current signal on a battery pack into a voltage signal to facilitate subsequent current sampling. Each signal conversion component 2 may be provided with a sampling point (that is, a first sampling point). For example, as shown in FIG. 1, the first signal conversion component 21 may include a sampling positive electrode S1P and a sampling negative electrode S1N, and the second signal conversion component 22 may also include a sampling positive electrode S2P and a sampling negative electrode S2N.

The conductive connector 1 may be any metal part with conductive properties. Specifically, the above conductive connector 1 may be a copper bar, and the copper bar may be a soft copper bar or a hard copper bar. More specifically, the above conductive connector 1 may be a copper bar (or also called a "soft copper bar").

The size of the conductive connector 1 may be obtained by simulation software according to heat dissipation analysis of different currents of a battery pack, and is not specifically limited here.

In this embodiment, the shunt module 100 may include conductive connectors 1 arranged at intervals in sequence and a plurality of signal conversion components 2, where the plurality of signal conversion components 2 may achieve multi-channel sampling. In this way, only the shunt module 100 can perform main sampling and redundant sampling to achieve the purpose of current detection, reduce the structure size, and facilitate miniaturization. At the same time, the use of a Hall sensor for sampling is avoided, which reduces the interference during the sampling process, thereby improving the current sampling accuracy.

In some embodiments, the plurality of conductive connectors 1 are spaced apart from each other, and the signal conversion component 2 is located within at least a portion of the interval between two adjacent conductive connectors 1.

In this embodiment, the plurality of conductive connectors 1 are spaced apart from each other, and the signal conversion component 2 is located within at least a portion of the interval between two adjacent conductive connectors 1, so that mutual interference between signals generated on the conductive connectors 1 can be reduced, and the sampling accuracy is higher.

The above signal conversion component 2 may be arranged in a portion of the interval between two adjacent conductive connectors, for example, the signal conversion component 2 occupies 1/4, 1/2 or 3/4 of the interval between two adjacent conductive connectors; or, the above signal conversion component 2 may fill the interval between two adjacent conductive connectors.

In some embodiments, the signal conversion component 2 is arranged between each two adjacent conductive connectors 1.

In this embodiment, the signal conversion component 2 is arranged between each two adjacent conductive connectors 1, that is, a signal conversion component 2 is respectively arranged between each two adjacent conductive connectors 1, so that the structure of the shunt module 100 is more compact, the structure size is further reduced, and miniaturization is facilitated.

The signal conversion component is arranged between each two adjacent conductive connectors 1, which can be understood that in a case that the number of the above conductive connectors 1 is N, the number of the above signal conversion components 2 is N-1.

In some embodiments, the shunt module 100 may further include:
a circuit board 3, the circuit board being arranged on one side of the plurality of conductive connectors 1, and the plurality of signal conversion components 2 being connected to the circuit board 3; and
a first signal transmission component 31 arranged on the circuit board 3, the first signal transmission component 31 being electrically connected to the first sampling point of each of the signal conversion components 2.

In this embodiment, as shown in FIG. 2, the shunt module 100 may further include a circuit board 3 and a first signal transmission component 31, and the circuit board 3 is arranged on one side surface of the signal conversion component 2 and the conductive connector 1, and can cover the signal conversion component 2 and part of the conductive connector 1. The circuit board, the signal conversion component 2, and the conductive connection component 1 can be soldered together by vacuum reflow soldering.

Exemplarily, the signal conversion component 2 can be soldered on the circuit board 3 by a surface mounted technology (SMT) to achieve electrical connection and facilitate subsequent signal transmission.

The first signal transmission component 31 can be soldered on the circuit board 3 through the SMT, and the first signal transmission component 31 can be configured to transmit the electrical signal generated on the shunt module 100 to a sampling plate 102 through a wiring harness to achieve the purpose of current sampling.

In this embodiment, the circuit board 3 can achieve the electrical connection between various components of the shunt module 100, and the first signal transmission component 31 can be configured to transmit the electrical signal acquired by the signal conversion component 2, thereby simplifying the assembly work, reducing wiring, achieving the purpose of saving space, and further reducing the structure size, which is conducive to miniaturization.

The circuit board 3 may be any board structure having connecting lines, and the connecting lines are configured to transmit electrical signals. Specifically, the circuit board 3 may be a hard circuit board or a soft circuit board.

In some embodiments, the shunt module 100 may further include:
a plurality of temperature sensors 4, the plurality of temperature sensors 4 being correspondingly arranged on the plurality of signal conversion components 2, the plurality of temperature sensors 4 being connected to the circuit board 3, each of the temperature sensors 4 being provided with a sampling point, and the sampling point of the temperature sensor 4 being configured to acquire the temperature of the signal conversion component 2.

In this embodiment, as shown in FIG. 1, the shunt module 100 may further include a temperature sensor 4, and the number of the temperature sensors 4 may be equal to the number of the signal conversion components 2. Thus, one temperature sensor 4 may be arranged corresponding to one signal conversion component 2. The temperature sensor 4 may be soldered on the circuit board 3 by a surface mounted technology (SMT) to achieve electrical connection, so as to facilitate subsequent signal transmission.

The above temperature sensor 4 is arranged corresponding to the signal conversion component 2, which can be understood that the temperature sensor 4 is only configured to acquire the temperature of the corresponding signal conversion component 2, and the corresponding temperature sensor 4 and signal conversion component 2 may be associated in the arrangement position. For example, the temperature sensor 4 may be fixedly connected to the corresponding signal conversion component 2; or, the corresponding temperature sensor 4 and signal conversion component 2 may also have other associations, such as electrical connection or relative and spaced arrangement, etc.

Taking an example of two temperature sensors 4, including a first temperature sensor 41 and a second temperature sensor 42, as shown in FIG. 1, the first temperature sensor 41 may be arranged corresponding to the first signal conversion component 21, and the second temperature sensor 42 may be arranged corresponding to the second signal conversion component 22. Each temperature sensor 4 may be provided with a sampling point. For example, the first temperature sensor 41 may include a sampling positive electrode N1P and a sampling negative electrode N1N, and the second temperature sensor 42 may also include a sampling positive electrode N2P and a sampling negative electrode N2N. The temperature sensor 4 can acquire the temperature of the signal conversion component 2 and transmit the temperature change of the signal conversion component 2 to the sampling plate 102 through the sampling point, so that the sampling plate 102 can compensate for the temperature drift of the signal conversion component 2.

In this embodiment, the temperature sensor 4 can acquire the temperature of the signal conversion component 2 so as to subsequently compensate for the temperature drift of the signal conversion component 2, thereby improving the sampling accuracy of the signal conversion component 2 and further improving the current detection accuracy.

In some embodiments, the shunt module 100 further includes:
a calibration mark 5, arranged on the circuit board 3.

In this embodiment, the shunt module 100 may further include a calibration mark 5 arranged on the circuit board 3, and the calibration mark 5 may include at least one of a bar code and a two-dimensional code. An initial resistance value and a temperature compensation coefficient of the shunt module 100 can be calibrated for the sampling plate 102 by scanning the calibration mark 5.

In this embodiment, the initial resistance value and the temperature compensation coefficient of the shunt module 100 can be calibrated by the calibration mark 5 to avoid the subsequent sampling deviation and improve the current sampling accuracy.

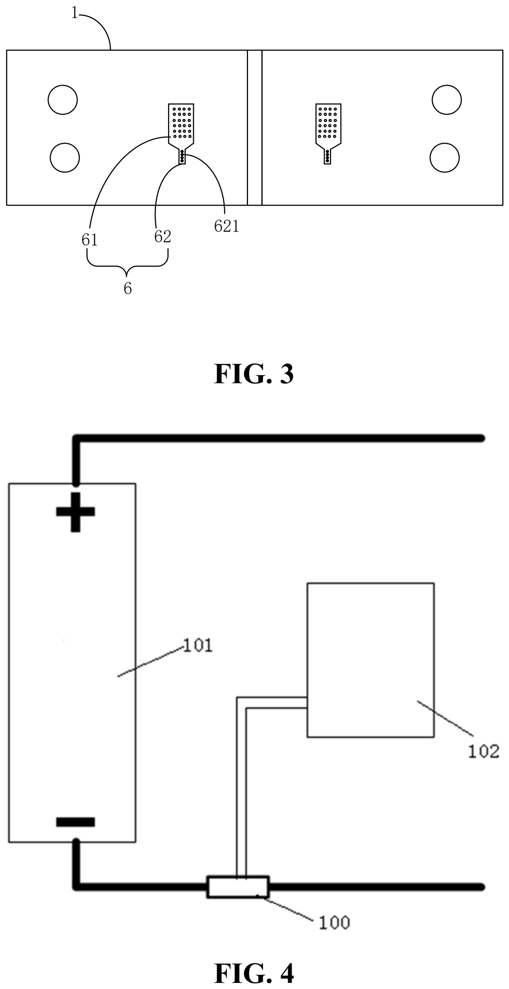

In some embodiments, as shown in FIG. 3, each of the plurality of conductive connectors 1 is provided with a third sampling point.

The shunt module 100 further includes:
N second signal transmission components 6, the N second signal transmission components 6 being correspondingly arranged at the third sampling points of N conductive connectors 1, and each signal transmission component 6 being electrically connected to the corresponding third sampling point.

In this embodiment, the electrical signals acquired by the third sampling points of the N conductive connectors 1 can be transmitted through the N second signal transmission components 6, so that the shunt module 100 can transmit the acquired electrical signals in more flexible and diverse manners.

In this embodiment, the above second signal transmission component 6 may be any structure having conductive properties, and the shape, size and material thereof may be set according to actual needs. For example, the above signal transmission component 6 may be a copper column arranged at the third sampling point.

The plurality of second signal transmission components 6 are correspondingly arranged at the third sampling points of the plurality of conductive connectors 1, meaning that the number of the second signal transmission components 6 may be the same as the number of the conductive connectors 1, and each second signal transmission component 6 is correspondingly arranged at the third sampling point of a conductive connector 1.

The above second signal transmission component 6 is correspondingly arranged at the third sampling point of the conductive connector 1, meaning that the second signal transmission component 6 may be electrically connected to the third sampling point of the corresponding conductive connector 1; or the second signal transmission component 6 may be associated with the position of the third sampling point, for example, the second signal transmission component 6 covers at least part of the corresponding third sampling point.

In some embodiments, the signal transmission component 6 includes:
a connecting plate 61, the connecting plate 61 being attached to at least a partial region of the conductive connector 1 and connected to the conductive connector 1, and the third sampling point being located within the at least partial region; and
a transmission part 62, the transmission part 62 being formed by extending the connecting plate 61, the transmission part 62 being electrically connected to the conductive connector 1 through the connecting plate 61, and the transmission part 62 being configured to transmit the electrical signal acquired by the conductive connector 1.

In this embodiment, the transmission part 62 is electrically connected through the connecting plate 61 fixedly connected to the conductive connector 1, and the connecting plate 61 is attached to the at least partial region of the conductive connector 1 including the third sampling point, so that the contact area between the signal transmission component 6 and the conductive connector 1 can be increased, thereby making the connection between the signal transmission component 6 and the corresponding conductive connector 1 more secure, and improving the stability of the shunt module 100.

In this embodiment, the above connecting plate 61 may be a plate-shaped structure having conductive properties, the connecting plate 61 covers the at least partial region of the conductive connector 1 including the third sampling point, and the size, shape, and material of the connecting plate 61 may be set according to actual needs. For example, the above connecting plate 61 may be a copper plate with a thickness of 1-2 mm.

The connection between the connecting plate 61 and the conductive connector 1 may be a fixed connection between the connecting plate 61 and the conductive connector 1, for example, the connecting plate 6 is soldered or riveted to the conductive connector 1.

The above transmission part 62 may be a component for connecting to an external signal receiving device and transmitting the electrical signal of the third sampling point to the external signal receiving device. For example, the transmission part 62 may be a socket fixedly connected to the connection plate 61, and the socket is provided with jacks.

The above transmission part 62 is formed by extending the connecting plate 61, which can be understood that the transmission part 62 and the connecting plate 61 are of an integral structure; or, the transmission part 62 and the connecting plate 61 may be two relatively independent structures and are interconnected.

In some embodiments, the transmission part 62 includes at least one contact pin 621.

In this embodiment, by arranging at least one contact pin 621 on the transmission part 62, connection with an external device can be achieved through the contact pin 621, which facilitates operation during a signal transmission process.

In some embodiments, different signal conversion components 2 have different structural features.

In this embodiment, different signal conversion components 2 have different structural features, which facilitates identification of a plurality of signal conversion components 2, so that during sampling, a sampled object can be determined according to the structural features of each signal conversion component, thereby improving the sampling efficiency.

The above different signal conversion components 2 have different structural features, which may be that different signal conversion components 2 have at least one different mark, color or size.

Specifically, the plurality of signal conversion components 2 have different resistance values and are made of the same material. Since the resistance values of the plurality of signal conversion components 2 are different in a case that the materials are the same, the sizes of the different signal conversion components 2 will inevitably be different.

In this embodiment, the number of the signal conversion components 2 may be two, including a first signal conversion component 21 and a second signal conversion component 22.

According to practical experience, when the charging and discharging power of a battery pack is maximized, it is necessary to ensure that the temperature of the signal conversion component 2 with a larger resistance value is within 140°C, otherwise, the reliability of the circuit board 3 and the components thereon will be affected. When the power is very high, in addition to cooling through active heat dissipation measures such as air cooling and water cooling, the resistance values of the first signal conversion component 21 and the second signal conversion component 22 can be limited because the larger the resistance value, the higher the heat energy generated.

The resistance value of the first signal conversion component 21 may be 20-30 uΩ, and preferably 25 uΩ. The resistance value of the second signal conversion component 22 may be 10-20 uΩ, and preferably 15 uΩ.

In this embodiment, two-channel current acquisition can be achieved through the first signal conversion component 21 and the second signal conversion component 22, which is conducive to miniaturization. At the same time, the resistance value thereof is limited to ensure the current sampling accuracy and functional reliability.

In some embodiments, the material of the plurality of signal conversion components 2 is any one of manganese-copper alloy, iron-chromium-aluminum alloy, and nickel-chromium alloy.

In this embodiment, the material of the signal conversion component 2 is any one of manganese-copper alloy, iron-chromium-aluminum alloy, and nickel-chromium alloy. For example, manganese-copper alloy may be used, which has the characteristics of high sensitivity, fast response, better linearity, and small resistance temperature coefficient, and can effectively ensure the current sampling accuracy of the shunt module 100.

In this embodiment, the material of the signal conversion component 2 may be selected from any one of manganese-copper alloy, iron-chromium-aluminum alloy, and nickel-chromium alloy according to actual needs. The shunt module 100 has very high flexibility to meet more diverse needs.

FIG. 4 is a schematic structural diagram of a current acquisition system provided in an embodiment of the present application. The current acquisition system includes:
a battery 101 and a sampling plate 102; and
the above shunt module 100,
where the battery 101 and the sampling plate 102 are respectively connected to the shunt module 100.

In this embodiment, as shown in FIG. 4, the current acquisition system may include a battery 101, a sampling plate 102, and a shunt module 100. The battery 101 and the sampling plate 102 may be connected to the shunt module 100 respectively. The shunt module 100 may perform multi-channel sampling of the current signal of the battery 101 and transmit the sampling signal to the sampling plate 102 for current detection, thereby analyzing the state of the battery 101.

In this embodiment, the current acquisition system may include the above shunt module 100. In this way, only the shunt module 100 can perform main sampling and redundant sampling to achieve the purpose of current detection, reduce the structure size, and facilitate miniaturization. At the same time, the use of a Hall sensor for sampling is avoided, which reduces the interference during the sampling process, thereby improving the current sampling accuracy.

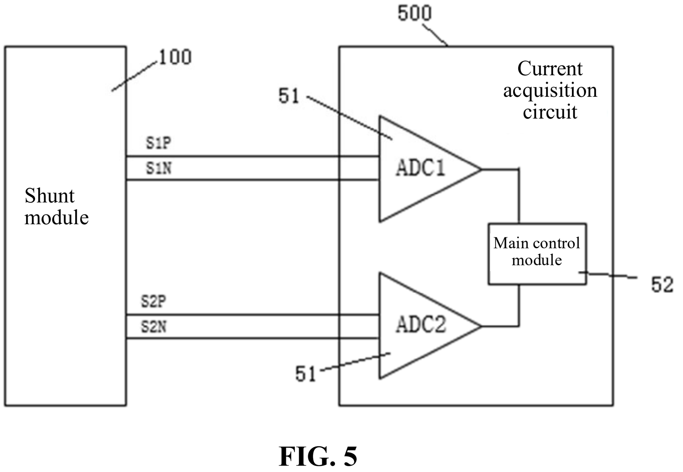

Referring to FIG. 5 to FIG. 7, an embodiment of the present application may further provide a current acquisition circuit 500, including:
a plurality of sampling modules 51, the plurality of sampling modules 51 being arranged corresponding to the plurality of signal conversion components 2 in the above shunt module 100; and
a main control module 52, the main control module 52 being configured to be connected to the plurality of sampling modules 51 respectively, and the main control module 52 being configured to obtain a current group of the plurality of sampling modules 51 according to the electrical signals acquired by the plurality of sampling modules 51.

In this embodiment, the current acquisition circuit may include a plurality of sampling modules 51, where the plurality of sampling modules 51 may be in one-to-one correspondence to the plurality of signal conversion components 2 in the shunt module 100. For example, the shunt module 100 includes a first signal conversion component 21 and a second signal conversion component 22, and the number of the corresponding sampling modules 51 is also two.

The main control module may include a central processing unit (CPU), which can be connected to the plurality of sampling modules 51 respectively, and is configured to receive the electrical signals acquired by the plurality of sampling modules 51, and analyze the electrical signals acquired by the plurality of sampling modules 51 to obtain a current group of the plurality of sampling modules 51.

Taking an example in which the shunt module 100 includes a first signal conversion component 21 and a second signal conversion component 22, correspondingly, a plurality of acquisition modules include a first sampling module ADC1 and a second sampling module ADC2, the first sampling module ADC1 is arranged corresponding to the first signal conversion component 21, and the second sampling module ADC2 is arranged corresponding to the second signal conversion component 22, the current group may include a sampling current corresponding to the first sampling module ADC1 and a sampling current corresponding to the second sampling module ADC2.

Specifically, in a case that the resistance of the first signal conversion component 21 is greater than the resistance of the second signal conversion component 21, a control module may be configured to perform state description calculation of a battery pack and overcurrent diagnosis according to the sampling current of the first sampling module ADC1, where the state description (State Of X, SOX) of the battery pack may include a state of charge (SOC) of a power battery, a state of health (SOH) of the power battery, and a state of power (SOP) of the power battery; and perform overcurrent diagnosis according to the sampling current of the second sampling module ADC2 and verify a sampling value of the first sampling module ADC1.

In this embodiment, the plurality of sampling modules 51 in the current acquisition circuit can be arranged corresponding to the plurality of signal conversion components 2 in the shunt module 100, and multi-channel current acquisition can be achieved through the plurality of sampling modules 51, thereby avoiding the use of a Hall sensor sampling circuit for current sampling, correspondingly reducing one power supply module, and simplifying the circuit structure.

The plurality of sampling modules 51 can be arranged corresponding to the plurality of signal conversion components 2 in the shunt module 100, the number of the sampling modules 51 may be the same as the number of the signal conversion components 2, and each sampling module 51 is electrically connected to the corresponding signal conversion component 2.

In some embodiments, the plurality of sampling modules 51 include at least one of a differential sampling subcircuit and a single-ended sampling subcircuit.

In this embodiment, it can be understood that single-ended sampling generally uses one signal line for sampling, while differential sampling often requires two signal lines for sampling. Compared with single-ended sampling, differential sampling has the following advantages:
1. The anti-interference ability is strong. Interference noise is generally loaded onto two signal lines with an equal value at the same time, and the difference is 0, that is, the noise has no effect on a signal.
2. The electromagnetic interference can be effectively inhibited. Since the two signal lines are close to each other and have equal signal amplitudes, the amplitudes of the coupled electromagnetic fields between the two signal lines and the ground line are also equal. At the same time, the signal polarities are opposite, and their electromagnetic fields will cancel each other out, so the electromagnetic interference to the outside is also small.

Compared with single-ended sampling, the disadvantages of differential sampling are:
Differential sampling requires two signal lines with an equal length and an equal width, close to each other and located on a same layer, while single-ended sampling may only have one signal line, and the ground line may be located on the ground plane. It can be seen that the space occupied by differential sampling is larger than that of single-ended sampling. If the area of the circuit board is very limited, single-ended sampling may be selected.

Based on this, this embodiment can select differential sampling or single-ended sampling according to actual conditions. Specifically, each sampling module 51 in the plurality of sampling modules 51 may be a differential sampling subcircuit; or, each sampling module 51 in the plurality of sampling modules 51 may be a single-ended sampling subcircuit; or, some sampling modules 51 in the plurality of sampling modules 51 may be differential sampling subcircuits, and another part of the sampling modules 51 may be single-ended sampling subcircuits.

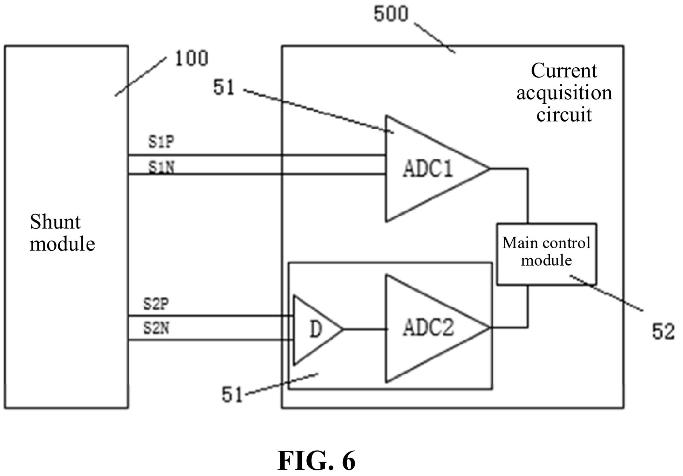

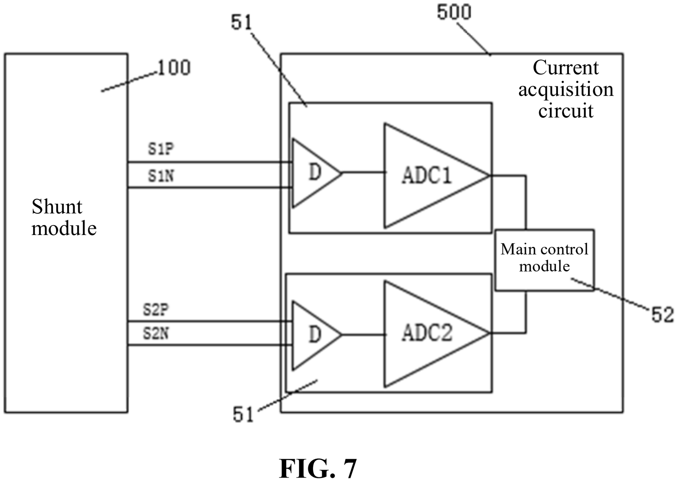

Taking an example in which the shunt module 100 includes a first signal conversion component 21 and a second signal conversion component 22, and correspondingly, N-1 acquisition modules include a first sampling module ADC1 and a second sampling module ADC2, as shown in FIG. 5, both the first sampling module ADC1 and the second sampling module ADC2 may include a differential sampling subcircuit. Or, as shown in FIG. 6, the first sampling module ADC1 may include a differential sampling subcircuit, and the second sampling module ADC2 may include a single-ended sampling subcircuit. Or, as shown in FIG. 7, both the first sampling module ADC1 and the second sampling module ADC2 may include a single-ended sampling subcircuit.

In this embodiment, the plurality of sampling modules 51 can select single-ended sampling or differential sampling according to actual conditions, so that the flexibility is higher, and diverse sampling scenarios and needs can be better satisfied.

An embodiment of the present application provides a vehicle, including the above current acquisition system or the above current acquisition circuit.

An embodiment of the present application further provides a vehicle. The vehicle may include the above current acquisition system or the above current acquisition circuit. In this way, since the current detection of the battery management system is more accurate and has higher reliability, the reliability of the vehicle during charging and discharging can be improved, and the risk of faults of the battery 101 can be reduced.

Although the present application has been described with reference to the preferred embodiments, various improvements may be made and components therein may be replaced with equivalents without departing from the scope of the present application. In particular, the technical features mentioned in various embodiments can be combined in any manner as long as there is no structural conflict. The present application is not limited to the specific embodiments disclosed herein, but includes all technical solutions falling within the scope of the claims.

## Claims

1. A shunt module, comprising:
a plurality of conductive connectors arranged in sequence; and
a plurality of signal conversion components, different signal conversion components in the plurality of signal conversion components being arranged between two different adjacent conductive connectors, each of the signal conversion components being provided with a first sampling point, and the sampling point being configured to acquire electrical signals.

2. The shunt module according to claim 1, wherein the plurality of conductive connectors are spaced apart from each other, and the signal conversion component is located within at least a portion of the interval between two adjacent conductive connectors.

3. The shunt module according to claim 1 or 2, wherein the signal conversion component is arranged between each two adjacent conductive connectors.

4. The shunt module according to any one of claims 1 to 3, further comprising:
a circuit board, the circuit board being arranged on one side of the plurality of conductive connectors, and the plurality of signal conversion components being connected to the circuit board; and
a first signal transmission component arranged on the circuit board, the first signal transmission component being electrically connected to the first sampling point of each of the signal conversion components.

5. The shunt module according to claim 4, further comprising:
a plurality of temperature sensors, the plurality of temperature sensors being correspondingly arranged on the plurality of signal conversion components, the plurality of temperature sensors being connected to the circuit board, each of the temperature sensors being provided with a second sampling point, and the second sampling point being configured to acquire the temperature of the signal conversion component.

6. The shunt module according to claim 4, further comprising:
a calibration mark arranged on the circuit board.

7. The shunt module according to any one of claims 1 to 6, wherein a third sampling point is arranged on each of the plurality of conductive connectors; and
the shunt module further comprises:
a plurality of second signal transmission components, the plurality of second signal transmission components being correspondingly arranged at the third sampling points of the plurality of conductive connectors, and each of the second signal transmission components being electrically connected to the corresponding third sampling point.

8. The shunt module according to claim 7, wherein the second signal transmission component comprises:
a connecting plate, the connecting plate being attached to at least a partial region of the conductive connector and connected to the conductive connector, and the third sampling point being located within the at least partial region; and
a transmission part, the transmission part being formed by extending the connecting plate, the transmission part being electrically connected to the conductive connector through the connecting plate, and the transmission part being configured to transmit the electrical signal acquired by the conductive connector.

9. The shunt module according to claim 8, wherein the transmission part comprises at least one contact pin.

10. The shunt module according to any one of claims 1 to 9, wherein different signal conversion components have different structural features.

11. A current acquisition system, comprising:
a battery and a sampling plate; and
the shunt module according to any one of claims 1 to 10,
wherein the battery and the sampling plate are respectively connected to the shunt module.

12. A current acquisition circuit, comprising:
a plurality of sampling modules, the plurality of sampling modules being arranged corresponding to the plurality of signal conversion components in the shunt module according to any one of claims 1 to 10; and
a main control module, the main control module being configured to be connected to the plurality of sampling modules respectively, and the main control module being configured to obtain a current group of the plurality of sampling modules according to the electrical signals acquired by the plurality of sampling modules.

13. The current acquisition circuit according to claim 12, wherein each of the plurality of sampling modules comprises at least one of a differential sampling subcircuit and a single-ended sampling subcircuit.

14. A vehicle, comprising the current acquisition system according to claim 11 or the current acquisition circuit according to claim 12.
